# EUROPEAN PATENT APPLICATION

(11) **EP 4 528 738 A2**
(43) Date of publication of application: **26.03.2025**
(21) Application number: 24196884.1
(22) Date of filing: 28.08.2024
(51) Int. Cl.: G11C 13/00

(54) **METHOD OF OPERATING PHASE CHANGE MEMORIES, CORRESPONDING DEVICE AND COMPUTER PROGRAM PRODUCT**

(30) Priority: 20.09.2023 IT 202300019332
(71) Applicant: STMicroelectronics International N.V., 1228 Plan-les-Ouates, Geneva (CH)
(72) Inventor: CONTE, Antonino, I-95030 Tremestieri Etneo (Catania) (IT); TOMAIUOLO, Francesco, I-95024 Acireale (Catania) (IT); JASSE, Jeremie Clement, I-20099 Sesto san Giovanni (Milano) (IT); GANDOLFO, Anna, I-20871 Vimercate (Monza Brianza) (IT)
(74) Representative: Buzzi, Notaro & Antonielli d'Oulx S.p.A.

(57) **Abstract**

Write operations (10) in a Phase Change Memory, PCM device include:
if a first set contains at least one cell set at a high logic level, performing (102) a reset write operation to set to a low logic level the cell by applying thereto at least one current reset pulse,
if a second set contains at least one cell set at a low logic level, performing (104) a set write operation to set to a high logic level the aforesaid cell.

Success or failure of the set write operation is verified (104) via at least one set verify operation to check if the at least one cell in the second set is set to a high logic level in response to the set write operation.

Success or failure of the reset write operation is verified (110) via at least one verify operation selected out of individual (106) and looped (108) reset write verify operations to check if the cell or cells in the first set is/are set to a low logic level in response to the reset write operation.

The write operation is considered as failed in response to said reset write operation being considered as failed (110) and/or to said set write operation being considered as failed (104).

## Description

### Technical field

The description relates to the field of data storage technologies.

One or more embodiments can be applied to various types of computer storage technologies such as PCM, that is, Phase Change Memory, for instance, ePCM (that is, embedded Phase Change Memory) and/or ePCM NVM (that is, Non-Volatile Memory ePCM).

### Background

Phase Change Memories, referred to as PCM, are a type of computer storage technology, that is, memory technology and, generally, a type of non-volatile random-access memory technology that may be embedded in integrated circuit (IC) semiconductor devices.

Usually, PCM operates on a bit-by-bit basis since the heat produced by an electric current flowing through a heating material called phase-change material such as, for instance, a chalcogenide glass, is used to melt and quench the phase-change material, making it amorphous, or to hold such phase-change material in its crystallization temperature range, thereby switching it to a crystalline state.

Therefore, a PCM storage unit may use such phase-change material to store 1-bit of information since the two states of the phase-change material, that is, amorphous or crystalline, are characterized by different resistance values that facilitate distinguishing one of the states from the other, that is, each of the two states corresponds to a different value of a single bit.

Thus, the phase-change material can stably exist in two states:
an amorphous or disordered state, characterized by high electrical resistivity, that is, by high resistance, representing, for instance, a low logical state, for instance, '0', or
a crystalline or ordered state, characterized by low electrical resistivity, that is, by low resistance, for example, a resistance lower than that of the amorphous state, representing, for instance, a high logical state, for instance, '1'.

A PCM storage unit can switch between such two states by differently heating the phase-change material, that is, by applying a current to such phase-change material for a given time for switching to a first state and by applying a current of different value to such phase-change material for a different time for switching to a second state.

For instance, a "set" write operation of a specific cell, that is, setting the cell to a high logic state, may be performed by applying on the phase-change material of such specific cell a current pulse with triangular shape.

Therefore, the current flowing within the PCM cell is increased rapidly up to a certain value, for instance, a value that may heat the respective phase-change material above a crystallization temperature associated to such respective phase-change material but under a melt temperature associated with the same phase-change material, and then is decreased slowly.

For instance, a "reset" write operation of a specific cell, that is, setting the cell to a low logic state, can be performed by applying on the phase-change material of such specific cell a short rectangular current pulse.

Therefore, the current flowing within the PCM cell is increased in a fast way up to a certain value, for instance, a value that may heat the respective phase-change material above the melt temperature associated with such respective phase-change material, and then is decreased after a small time, for instance, 100 ns, in a fast way. For instance, a read operation of a specific cell may involve measuring the resistance value of the phase-change material of the specific cell and the respective state of such specific cell, that is, amorphous or crystalline, by applying thereto a given voltage variation and by measuring the respective current flowing therein.

It is noted that after any write operation, that is, a reset or a set write operation, a write verify operation is usually performed, that is, a read operation used to check the success of a corresponding write operation, and:
- if the write verify operation is considered successful (that is, if the read operation used to check the success of the corresponding write operation is considered successful, in that the read operation detects that a cell associated with such corresponding write operation contains the correct value that should be written in such cell) the corresponding write operation ends as the value contained in the cell is correct, thus, the write operation was successful, and
- if the write verify operation is considered unsuccessful (that is, if the read operation detects that a cell associated with such corresponding write operation contains a value that is different from the correct one that should be written in such cell), the write operation is to be applied again, that is, a current is applied again to the cell in order to repeat the write operation.

Therefore, write verify operations may be:
- reset write verify operations, used to check if the cells to be reset, that is, to be set to a low logic level in response to a reset write operation, are effectively in a reset state, that is, set to a low logic level, after a corresponding reset pulse; and
- set write verify operations, used to check if the cells to be set, that is, to be set to a high logic level in response to a set write operation, are effectively in a set state, that is, set to a high logic level, after a corresponding set pulse.

A single-ended PCM is a type of PCM wherein a single cell corresponds to a single bit (that is, 1 cell/bit).

Read operations in single-ended PCM are performed by using a reference current supplied, for instance, by a reference current generator, and a sense amplifier receiving:
at one terminal, a current from a PCM cell that is read, and
at the other terminal, a reference current supplied by the reference-current generator.

Such sense amplifier is further configured to compare such current received from the PCM cell that is read with such reference current in order to determine the logic level store within such PCM cell that is to be read, that is, its state.

Single-ended PCM architectures are affected by resistance drifts resulting from the relaxation phenomenon of amorphous materials, that is, an intrinsic behavior of the amorphous state of phase-change materials resulting in an increase of their resistance values.

In response to a "reset" write operation, the resistance of the amorphous phase-change material starts increasing over time. Such an increase is a consequence of the relaxation that affects the amorphous state of phase-change materials and results from a rearrangement in the atomic configuration of such amorphous phase-change material over time.

In response to such a reset write operation, the phase-change material is rapidly quenched and its atomic configuration is frozen in a highly stressed state, that is, the amorphous state.

The atomic configuration of the amorphous state of the phase-change material is rearranged over time in a configuration with lower free energy. Such rearrangement is a result of thermally-activated annihilation of trapping centers, for instance, vacancies, dangling bonds, or disorder-induced localized states, and leads to a resistance increase over time.

Thus, the observed resistance drift, that is, an increased resistance value, of the amorphous phase-change material is a result of an intrinsic behavior of such amorphous phase-change material, that is, atomic configuration rearrangements resulting from an attempt of lowering the free energy in such configuration.

Such resistance drift results in a variation of the resistance value of a PCM cell during its life, starting from a minimum resistance value right after a reset write operation, that is, when rearrangements resulting from the relaxation effect are still negligible, and increasing over time.

Therefore, a disadvantage of single-ended PCM architectures is the difficulty of selecting a reference current that is constant during the entire working life of the PCM cell.

In fact, such reference current should desirably:
be placed between a first current range comprising the currents that may pass through a cell when the state of the cell is set to a high logic state and a second current range comprising the currents that may pass through the same cell when the state of the cell is set to a low logic state, such second current range varying as a function of the changes of the resistance value of the phase-change material during the life of the PCM cell, and
maintain a certain distance from both the first and the second current range to ensure reliability and retention of non-volatile memory.

The relaxation effect impacts on read operations of PCM cells that are in a "reset" state, that is, contain a low logic level, since the resistance of the phase-change material changes over time, making more difficult to select a fixed reference current for read operations.

A possible solution may be the use of two cells per bit PCM architectures as disclosed in patent document US 2009/0161417 A1.

Document US 2009/0161417 A1 discloses two cells per bit PCM architecture (that is, 2 cell/bit), that is, PCM architecture wherein two cells contain a single bit of data and one of the two cells, a complement cell, is programmed to the complementary state of the other of the two cells.

Thus, a bit is determined by reading a bit stored in one of the two cells and comparing it to the one stored in the complement cell.

Thus, in two-cells-per-bit PCM architectures a reference current is not needed since a read operation of any data, that is, a high or low logic state, is based on the stored value of such data in a cell in its direct form, that is, high or low logic state respectively, the stored value of such data in a complement cell in its complemented form, that is, low or high logic state respectively, and on the use of a sense amplifier that is configured to receive at one terminal a current of the "direct" cell that has to be read, that is, containing the data in the direct form, and at the other terminal a current of the associated complement cell, that is, containing the data in the complemented form.

Both the occupied area and the production cost of two- cells-per-bit PCM architectures considerably increase with respect to single-ended PCM architectures, since two cells, instead of a single one, are used to store a single bit.

Solutions that decrease the impact of the resistance drift of single-ended PCM architectures would be beneficial in order to reduce production costs and the required area of PCM architectures without sacrificing PCM durability.

### Object and summary

An object of one or more embodiments is to contribute in providing such a solution.

According to one or more embodiments, that object is achieved via a method for performing a PCM write operation having the features set forth in the claims that follow.

One or more embodiments concern a corresponding memory device and a corresponding computer program product loadable in at least one processing circuit (e.g., a computer) and comprising software code portions for executing the steps of the method when the product is run on at least one processing circuit. As used herein, reference to such a computer program product is understood as being equivalent to reference to a computer-readable medium containing instructions for controlling a processing system in order to coordinate implementation of the method according to one or more embodiments.

The claims are an integral part of the technical teaching provided in respect of the embodiments.

Solutions as described herein include a method of performing write operations, that is, writing data comprising one or more bits, in a Phase Change Memory, PCM device, the PCM device comprising a first set of cells and a second set of cells configured to be set to a low logic level and to a high logic level, respectively, in response to a write operation comprising reset write operations and/or set write operations.

A method according to solutions as described herein involves:
if the first set is a non-empty set that contains at least one cell set at a high logic level, performing a reset write operation to set to a low logic level said at least one cell in the first set by applying thereto at least one current reset pulse, that is, to reset the value contained in such at least one cell to a low logic level,
if the second set is a non-empty set contains at least one cell set at a low logic level, performing a set write operation to set to a high logic level such at least one cell in the second set, that is, to set the value contained in such at least one cell to a high logic level.

Success or failure of the set write operation is verified via at least one set verify operation to check if the at least one cell in the second set is set to a high logic level in response to the set write operation.

The set write operation is considered:
i) successful, in response to said at least one set verify operation indicating that the at least one cell in the second set is set to a high logic level in response to the set write operation, and
ii) failed, in response to said at least one set verify operation indicating that the at least one cell in the second set is set to a low logic level in response to the set write operation.

Success or failure of a reset write operation is verified via at least one verify operation that may be one or more reset write verify operation(s) out of individual and/or looped reset write verify operations to check if the at least one cell in the first set is set to a low logic level in response to the reset write operation.

The reset write operation is thus considered:
i) successful, in response to any of the individual and looped reset write verify operations indicating that the at least one cell in the first set is set to a low logic level in response to the reset write operation, and
ii) failed, in response to all of the individual and looped reset write verify operations indicating that the at least one cell in the first set is set to a high logic level in response to the reset write operation.

The write operation is considered as failed in response to said reset write operation being considered as failed and/or to said set write operation being considered as failed.

Solutions as described herein facilitate achieving single-ended PCM architectures that minimize, that is, reduce or substantially remove, that is, making it negligible, the impact of the resistance drift of a phase-change material, reducing production costs and the required area of PCM architectures without sacrificing their durability.

### Brief description of the figures

One or more embodiments will now be described, by way of example only, with reference to the annexed figures, wherein:
Figure 1 is a graph showing an example of current distributions in a PCM cell at different time instants;
Figure 2 is a block diagram of a method for a write operation according to embodiments of the present description;
Figure 3 is a block diagram showing an example of the method for a write operation according to embodiments of the present description; and
Figure 4 is a block diagram of a method for performing reset verify reading attempts.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

Architectures of Phase Change Memory, PCM devices comprise a first set of cells and a second set of cells configured to be set to a low logic level and to a high logic level, respectively, in response to a write operation comprising both reset write operations and/or set write operations.

It is noted that the first set of cells may be also the empty set, that is, if the data to be written in the PCM memory is composed of bits all set to a high logic level.

Similarly, it is noted that the second set of cells may be also the empty set, that is, if the data to be written in the PCM memory is composed of bits all set to a low logic level.

Such write operations in the PCM device are performed under the control of control unit programmed to operate as discussed in the following so that:
if the first set contains at least one cell set at a high logic level, a reset write operation is performed to set to a low logic level such a cell in the first set by applying thereto at least one current reset pulse,
if the second set contains at least one cell set at a low logic level, a set write operation is performed to set to a high logic level such a cell in the second set.

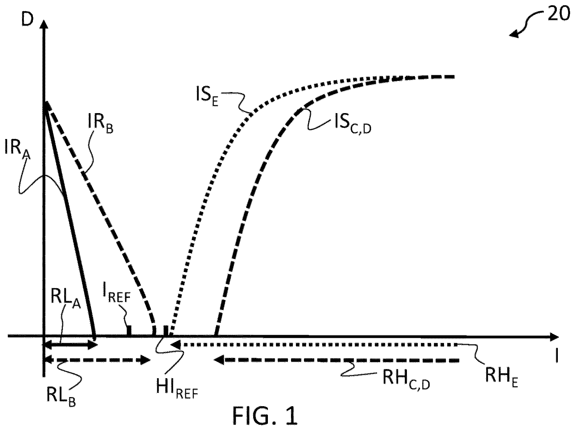

Figure 1 is a graph 20 showing an example of current distributions, generally referred to as IR for distributions of currents passing (flowing) through cells after reset write operations and IS for distributions of currents passing through cells after set write operations, in a portion of a PCM array, that is, a group of cells, at different time instants A-E, having on its x-axis current measurements I expressed, for instance, in µA, and on its y-axis distributions D.

The current distributions IR, IS shown in Figure 1 are illustrated by way of example only: other current distributions are possible without departing from the scope of the embodiments.

Exemplary current distributions IS may be distributions of current ranges RH_{C,D}, RH_{E} comprising currents that may pass through a portion of a PCM array, that is, a group of cells, when the states of the cells comprised therein are set to a high logic state, for instance, to "1", while exemplary current distributions IR may be distributions of current ranges RL_{A}, RL_{B} comprising currents that may pass through the same portion of the PCM array when the states of the cells comprised therein are set to a low logic state, for instance, to "0".

For instance, a first current distribution IS_{C,D} of a first current range RH_{C,D} related to a portion of a PCM array, that is, a group of cells, after a set write operation may remain substantially stable over time. For instance, such first current distribution IS_{C,D} may be the same in a first time instant C and a second time instant D, indicating respectively a moment after a given amount of time from a set write operation, for instance, after days, and a moment right after the same set write operation, that is, after a given amount of time that is significantly smaller than the amount of time considered for the first time instant C, for instance, few instants after the set write operation.

In fact, the first current range RH_{C,D} is associated with currents that may pass through a portion of a PCM array when the state of the cells comprised therein is set to a high logic state, that is, when such cells comprised therein are in a crystalline state that is not affected by relaxation and thus characterized by a constant resistance.

Conversely, current distributions associated with a portion of a PCM array, that is, a group of cells, after a reset write operation may vary over time as the respective current ranges RL_{A}, RL_{B} are associated with currents that may pass through a portion of a PCM array when the state of the cells comprised therein is set to a low logic state, that is, when such cells comprised therein are in an amorphous state that is affected by relaxation and thus characterized by a resistance that increases over time.

Therefore, a second current distribution IR_{A} of a second current range RL_{A} obtained in a third time instant A and related to a portion of a PCM array after a reset write operation may be different from a third current distribution IR_{B} of a third current range RL_{B} obtained in a fourth time instant B and related to the same portion of a PCM array after the same reset write operation, wherein the third time instant A indicates a moment after a given amount of time from the reset write operation, that is, when rearrangements resulting from the relaxation effect are affecting the resistance value of the phase-change material of the cells comprised therein of a non-negligible amount and the fourth time instant B indicates a moment right after a reset write operation, that is, when rearrangements resulting from the relaxation effect are still negligible, not affecting the resistance value of the phase-change material of the cells comprised therein, for instance, few instants after the reset write operation.

In fact, in the fourth time instant B, that is, right after a reset write operation (when rearrangements resulting from the relaxation effect are still negligible), the resistance value of the phase-change material of such cells comprised therein reaches its minimum value, thus, currents that may pass through such cells at such fourth time instant B may reach higher values if compared with those that may pass through the same cells in moments after the fourth time instant B, for instance, in the third time instant A, as the resistance value of the phase-change material increases over time in response to the relaxation effect of the amorphous state of the phase-change material.

As previously described, read operations in single-ended PCM are performed using a reference current supplied, for instance, by a reference current generator, such reference current I_{REF} being optionally:
placed between a first current range comprising the currents that may pass through cells, for instance, a group of cells comprised in a PCM array, when the state of the cells is set to a high logic state and a second current range comprising the currents that may pass through the same cells when the state of the cells is set to a low logic state, and
maintained at a certain distance, for instance, an equal distance, from both the first and the second current range to improve reliability and favor the retention of non-volatile memory.

Such read operations are performed, for instance, in response to a user request, after a given amount of time from a reset write operation, for instance, in the third time instant A, hence, the second current range RL_{A} obtained in such third time instant A may be considered as one of the ranges used to define the reference current I_{REF} for PCM architecture. The other of the ranges that may be used to define such reference current I_{REF} may be the substantially constant first current range RH_{C,D}.

However, it is noted that the first current distribution IS_{C,D} of the first current range RH_{C,D} may vary in response to set resistance drifts, such set resistance drift being dependent on temperature and time., that is, an increasing of the resistance, of the phase-change material of the cells within a PCM array.

Such set resistance drift that is may be a result of a change in the composition of the phase-change material in response to thermal atomic diffusion or collision against electrons at high temperatures, resulting in electromigration, leading to the movement of atoms of the phase-change material and resulting in a change in the composition of such phase-change material.

Such set resistance drift leads to a consequent lowering of the currents that passes through the cells comprised within a corresponding array, thus, the first current range RH_{C,D} and the first current distribution IS_{C,D} shift towards a fourth current range RH_{E} and a corresponding fourth current distribution IS_{E} respectively.

Therefore, to avoid failures of read operations after such set resistance drift, the other of the ranges used to define such reference current I_{REF} may be the fourth current range RH_{E}, obtaining the reference current I_{REF} as illustrated in Figure 1.

However, as illustrated in Figure 1, currents that passes through a portion of a PCM array at the fourth time instant B may be higher than the selected reference current I_{REF}, resulting in a possible failure in reading the content of such cells comprised therein if a read operation is performed at the fourth time instant B or shortly thereafter.

For instance, if a read operation is performed at the fourth time instant B, that is, right after such reset write operation, when rearrangements resulting from the relaxation effect are still negligible, to check the success of a reset write operation, the read operation, that in this case is referred to as reset verify operation, could fail, and therefore, the respective reset write operation will consequently be considered as failed, resulting in a high number of reset write attempts at increasing currents that may damage the cells after (many) writing cycles, that is, creating open bits that affect the durability of the PCM.

A possible solution may be obtained by performing reset verify operations, or any other similar read operation performed at the fourth time instant B or shortly thereafter, considering a second reference current HI_{REF}, such second reference current HI_{REF} having a higher value than that of the reference current I_{REF}.

The use of the second reference current HI_{REF} with a higher value than that of the reference current I_{REF} may affect the reliability of read operations, as a set state, that is, a high logic value, of a group of cells may be mistaken with a reset state, that is, a low logic value, of the same group of cells since the resistance of the phase-change material of such cells when their state is a set state may be affected by the long-term drift phenomenon that results in a decreasing of the currents that may pass through such cells in the set state, moving the fourth current range RH_{E} towards the higher reference current HI_{REF}.

It is noted that both the wear of the PCM memory and high temperatures may increase such a long-term drift phenomenon affecting the cells in a set state.

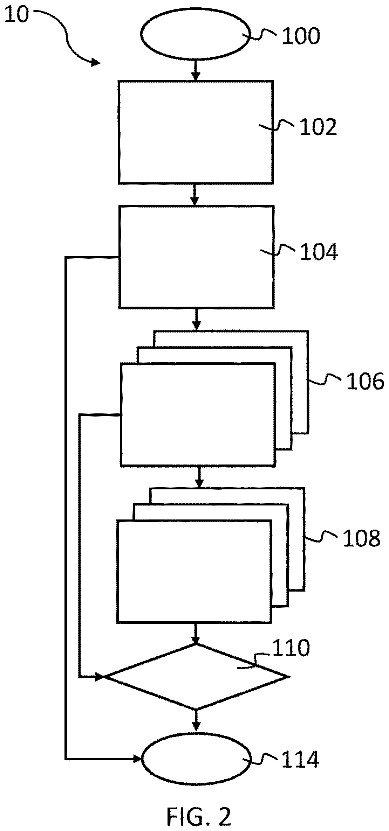

Figure 2 is a block diagram of a method 10 for a write operation, that is, an operation to write data of any number of bits, for instance, 32 bits, in the PCM memory wherein a set of such bits, for instance, 16 bits, are to be set to a high logic level, that is, the second set, and the remaining bits, for instance, 16 bits, are to be set to a low logic level, that is, the first set, such write operation comprising performing both set write operations and reset write operations and including respective verify operations, that is, set verify operations and reset verify operations respectively, to check the correctness of both set write operations and reset write operations of cells containing bits that are to be set to a high logic level and to a low logic level respectively according to embodiments of the present description.

It is noted that the first set of cells may be composed of any number of cells (any number smaller than the total number of bits of data to be written in the PCM memory) and that may be also the empty set, that is, if data to be written in the PCM memory is composed of bits all set to a high logic level.

Similarly, it is noted that the second set of cells may be composed of any number of cells (any number smaller than the total number of bits of data to be written in the PCM memory) and that may be also the empty set, that is, if data to be written in the PCM memory is composed of bits all set to a low logic level.

The method 10 is based on a balance between individual reset verify operations and loops of reset verify operations, considered respectively to minimize the impact of relaxation on the time of execution of write operations and improve the reliability of read operations to avoid a high number of reset write attempts at increasing currents, that is, current reset pulses, RP, that may damage a cell after many writing cycles, that is, generating "open bits".

Therefore, the method 10 comprises - at least - the following operations:
if one or more cells are to be set to a low logic level and if at least one of such one or more cells is set to a high logic level, performing 102 one or more reset write operations on at least such at least one of such one or more cells, that is, to reset the value contained in such at least one of such one or more cells to a low logic level,
if one or more cells are to be set to a high logic level and if at least one of such one or more cells is set to a low logic level, performing 104 one or more set write operations on such one or more cells, that is, to set the value contained in such one or more cells to a high logic level,
if one or more cells are to be set to a high logic level, performing 104 at least one set verify operation on such one or more cells, that is, to check if the cells in the second set are set to a high logic level,
considering 104 a corresponding set write operation as failed if the at least one set verify operation fail, that is, the at least one high logic level check fail for at least a cell in the second set,
considering 104 the corresponding set write operation as successful if at least one set verify operation is successful, that is, at least one high logic level check is successful for the cells in the second set, for instance, the performing of set verify operations may end in response to a first detection of a successful set verify operation without performing following set verify operations,
if one or more cells are to be set to a low logic level, performing 106 at least one individual reset verify operation on such one or more cells, that is, to check if the cells in the first set are set to a low logic level,
if one or more cells are to be set to a low logic level and the previously performed reset verify operations fail, performing 108 at least one loop of reset verify operations on such one or more cells, that is, to check again and using a loop if the cells in the first set are set to a low logic level,
considering 110 a corresponding reset write operation as failed if all of the reset verify operations both of the at least one individual reset verify operation and the at least one loop of reset verify operations fail, that is, if performed reset verify operations and performed loop of reset verify operations fail, that is, the low logic level checks fail for at least a cell in the first set,
considering 110 the corresponding reset write operation as successful if at least one of the reset verify operations both of the at least one individual reset verify operation and the at least one loop of reset verify operations is successful, that is, if at least one of the performed reset verify operations and performed loop of reset verify operations is successful, that is, a low logic level check is successful for the cells in the first set, for instance, the performing of reset verify operations may end in response to a first detection of a successful reset verify operation without performing following reset verify operations or loops of reset verify operations, and
considering 110 the corresponding write operation as failed if at least one of the reset write operations and set write operations fails 110, 104.

After a failure of a set write operation, additional set write operations and set verify operations may be performed before determining a failure of the corresponding write operation.

Further set write operations, that is, set write operations following failed set write operations, may be performed with current set pulse of increased value.

It is noted that if each of the performed set write operations fails, for instance, a maximum number of performed set write operations fails, the method 10 may advantageously end (that is, the set write operations step 104 may be further configured to check if each of such maximum number of set write operations fails and, if that is the case, to proceed to an ending block 114) before performing other steps, for instance, reset verify operations 106 and 108.

After a failure of a reset write operation, additional reset write operations out of individual reset verify operations and/or loops of reset verify operations may be performed before determining a failure of the corresponding write operation.

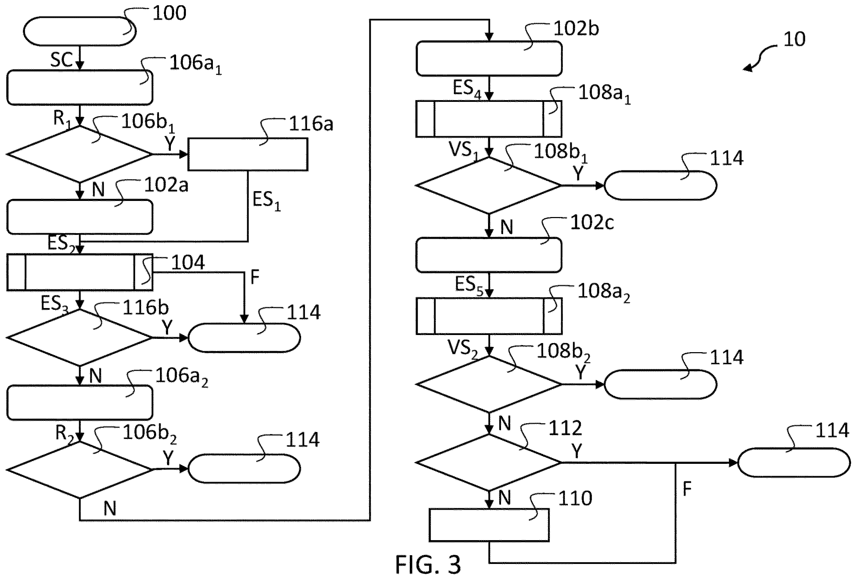

In the exemplary embodiment shown in Figure 3, the corresponding write operation may be considered as successful as soon as a first set verify operation is considered successful and a first reset verify operation is considered successful, without performing the subsequent set verify operations and/or reset verify operations (both individual reset verify operations 106 and looped reset verify operations 108).

Therefore, the method 10 may comprise considering 110 the write operation as successful and discontinuing set write verify operations and reset write verify operations in response to a first set write verify operation and a first reset write verify operation indicating that the cells in the first and in the second set are set to a low logic level or a high logic level respectively in response to the write operation.

The steps of the method 10 may be performed in a different order, for instance, by performing first a reset verify operation step 106, then a reset write operations step 102 followed by a set write operations step 104, and then again a reset verify operations steps 106 and/or 108, or other orderings.

The reset verify operations steps 106 and/or 108 may be performed a plurality of times as different steps of the method 10, for instance, the reset verify operations steps 106 may be performed both before the reset write operation step 102 and after the set write operations step 104.

It is noted that it may be advantageous to perform the set write operations step 104 after the reset write operations step 102 and before the reset verify operations steps 106 and/or 108 to benefit from the delay introduced by such set write operations between the reset write operations and reset verify operations, such delay being dependent on the time taken in performing the set write operations in such set write operations step 104, thus, facilitating the obtaining of a successful reset verify operation in such reset verify operations steps 106 and/or 108 since the resistance of the cells subject to such reset write operation in such reset write operations step 102 is increased in response to the relaxation phenomenon being partially run out.

It may be advantageous to perform a reset verify operations step 106 before a reset write operations step 102 so that if the cells to be set to a low logic level in such reset write operations step 102 are already set to such low logic level, the reset write operations step 102 may not be performed.

Similarly, it may be advantageous to perform (within the step referred to as 104) a set verify operation before set write operations so that if the cells to be set to a high logic level in such set write operations are already set to such high logic level, the set write operations may not be performed.

It may be advantageous to perform reset verify operations steps 106 (lasting for a time T1) comprising at least one individual reset verify operation before reset verify operations steps 108 (lasting for a time T2 which is higher than such time T1) comprising at least one loop of reset verify operations since a majority of the reset write operations will be concluded in response to performing, for instance, only a reset verify operations step 106 comprising one or more of the individual reset verify operations, thus, resulting in a reduction of the execution time needed for such reset write operations.

To summarize, the method 10 may comprise performing at least one individual reset write verify operation 106 prior to the looped reset write verify operations 108.

Other steps different from those reported in Figure 2 may be present, for instance, additional steps 112 or 116 described in the following for Figure 3.

Looped reset verify operations 108 may not be performed if a successful individual reset verify operation 106 has already been performed on same cells.

To summarize, in solutions disclosed herein, a method 10 of performing write operations in a Phase Change Memory, PCM device is disclosed. The PCM device comprising a first set of cells (that may be also an empty set) and a second set of cells (that may be also an empty set) configured to be set to a low logic level and to a high logic level, respectively, in response to a write operation comprising set write operations and/or reset write operations, wherein the method 10 comprises:
if the first set contains at least one cell set at a high logic level, performing 102 a reset write operation to set to a low logic level such at least one cell in the first set, thus, resetting to a low logic level the value of such at least one cell in the first set,
if the second set contains at least one cell set at a low logic level, performing 104 a set write operation to set to a high logic level such at least one cell in the second set, thus, setting to a high logic level the value of such at least one cell in the second set,
verifying 104 success or failure of the set write operation via at least one set verify operation to check if the at least one cell in the second set is set to a high logic level in response to the set write operation, that is, if the set write operation performed is successful,
considering 104 the set write operation:
   i) successful, in response to said at least one set verify operation indicating that the at least one cell in the second set is set to a high logic level in response to the set write operation, and
   ii) failed, in response to said at least one set verify operation indicating that the at least one cell in the second set is set to a low logic level in response to the set write operation;
verifying 110 success or failure of the reset write operation via at least one verify operation selected out of individual 106 and looped 108 reset write verify operations to check if the at least one cell in the first set is set to a low logic level in response to the reset write operation, that is, if the reset write operation performed is successful,
considering 110 the reset write operation:
   i) successful, in response to any of said individual 106 and looped 108 reset write verify operations indicating that the at least one cell in the first set is set to a low logic level in response to the reset write operation, and
   ii) failed, in response to all of said individual 106 and looped 108 reset write verify operations indicating that the at least one cell in the first set is set to a high logic level in response to the reset write operation; and
considering the write operation as failed in response to said reset write operation being considered as failed 110 and/or to said set write operation being considered as failed 104.

Figure 3 is a block diagram showing an example of the method 10 for a write operation according to embodiments of the present description.

The method 10 starts in a start write operation block 100 configured to receive an indication comprising instructions for a write operation, that is, for the writing of data composed of a given number of bits in a memory location, and to send a start command SC to a first reset verify operation block 106a₁.

The first reset verify operation block 106a₁ is configured to receive the start command SC and, in response to its reception, it is further configured to perform a read operation, referred to as reset verify operation, on the cells of the memory location that contain bits that are to be set to a low logic level in the write operation and to provide the results R₁ of such read operations to a first reset verify operation check block 106b₁.

The first reset verify operation check block 106b₁ is configured to receive the results R₁ of the read operations and to check if all of the results R₁ of the read operations are set to a low logic level.

If the check is successful, that is, if all of the results R₁ of the read operations are set to a low logic level, the first reset verify operation check block 106b₁ is configured to send a successful check signal Y to an end reset block 116a, otherwise, if the check is not successful, that is, if at least one of the results R₁ of the read operations is set to a high logic level, the first reset verify operation check block 106b₁ is configured to send an unsuccessful check signal N to a first reset write operation block 102a.

The end reset block 116a is configured to receive the successful check signal Y from the first reset verify operation check block 106b₁ and, in response to its reception, it is further configured to set the value of an end reset variable ER, for instance, by writing its value in a specific memory location, in order to record that the reset verify operations on each of the cells of the memory location that contains a bit that is to be set to a low logic level are successful and to send an end signal ES₁ to a set write operation block 104.

The first reset write operation block 102a is configured to receive the unsuccessful check signal N from the first reset verify operation check block 106b₁ and, in response to its reception, it is further configured to perform a reset write operation on each of the cells of the memory location that contains a bit that is to be set to a low logic level in the write operation. Such reset write operations are performed using a first current reset pulse RP₁ with a value of, for instance, 240 µA (microA): of course, that value is merely exemplary and non-limiting.

The reset write operation blocks 102 may be configured to perform reset write operations on each of the cells of the memory location that contains a bit that is to be set to a low logic level in the write operation and whose value is currently set to a high logic level.

The first reset write operation block 102a is further configured to send an end signal ES₂ to the set write operation block 104 after performing the reset write operations.

The set write operation block 104 is configured to receive an end signal ES₁, ES₂ from the end reset block 116a or the first reset write operation block 102a and, in response to its reception, it is further configured to perform a set write operation on each of the cells of the memory location that contains a bit that is to be set to a high logic level in the write operation and to send an end signal ES₃ to an end reset check block 116b.

Such set write operation block 104 may be configured to perform also set verify operations to check if the performed set write operations end successfully.

Set write operations and set verify operations can be performed in loops, for instance, the following operations may be performed:
- a first set verify operation is performed to check if at least one cell of the cells that are to be set to a high logic level is set to a low logic level,
- if such first set verify operation fails, a first set write operation is performed, by providing a first set pulse to such at least one cell,
- a second set verify operation is performed to check if such at least one cell is set to the high logic level, and
- if such second set verify operation fails, a second set write operation is performed, by providing a second set pulse, for instance, with a value higher than such first set pulse, to such at least one cell.

A set verify operation with a corresponding set write operation may be repeated on such at least one cell for a given number of times until:
- a set verify operation is considered successful, thus, considering the performed set write operation as successful; or
- the number of repetitions of such set verify operations and corresponding set write operations reaches a given maximum number of repetitions, thus, considering the performed set write operation as failed.

If the number of repetitions of set verify operations and set write operations reaches such given maximum number of repetitions, such set write operation block 104 may be further configured to set the value of a failure variable F, for instance, by writing its value in a specific memory location or sending an alert, for instance, to the microprocessor, the microcontroller, the logic circuit, or others, in order to record that the write operation of the respective cells is considered failed, and to send such failure variable F to an end write block 114 (described below).

The set write operation block 104 may be configured to perform set write operations on each of the cells of the memory location that contains a bit that is to be set to a high logic level in the write operation and whose value is currently set to a low logic level.

The end reset check block 116b is configured to receive the end signal ES₃ and to check if the end reset variable ER is set, for instance, by reading its value in the specific memory location and comparing it with a desired reference value, for instance, a logic value set to a high logic level.

If the check is successful, that is, if the value of the end reset variable ER is equal to that of reference, the end reset check block 116b is configured to send a successful check signal Y to the end write block 114, otherwise, if the check is not successful, that is, if the value of the end reset variable ER is different from that of reference, the end reset check block 116b is configured to send an unsuccessful check signal N to a second reset verify operation block 106az.

The end write block 114 is configured to receive a successful check signal Y or a failure signal F and to signal, for instance, to a microprocessor, a microcontroller, a logic circuit, or others, the conclusion of the write operation.

The end write block 114 may be configured to send an indication, for instance, to the microprocessor, the microcontroller, the logic circuit, or others, comprising the result of the write operation, for instance, fail/success, an indication of the cells with incorrect values in case of failure, or others.

The second reset verify operation block 106a₂ is configured to receive the unsuccessful check signal N from the end reset check block 116b and, in response to its reception, it is further configured to perform a read operation, referred to as reset verify operation, on the cells of the memory location that contain bits that are to be set to a low logic level in the write operation and to provide the results Rz of such read operations to a second reset verify operation check block 106b₂.

It is noted that such second reset verify operation block 106a₂ can be configured to be performed after the set write operation block 104, that is, after set write operations and set verify operations that may also be looped as described above, to introduce a delay between the reset write operation performed by the first reset write operation block 102a and the subsequent reset verify operation performed by such reset verify operation block 106az.

Therefore, such delay may depend on the time taken in performing the operations in the set write operation block 104, that is, the time taken by set write operations and set verify operations, facilitating the obtaining of a successful reset verify operation since the resistance of the cells subject to such reset write operation is increased in response to the relaxation phenomenon being partially run out.

The second reset verify operation check block 106b₂ is configured to receive the results R₂ of the read operations and to check if all of the results R₂ of the read operations are set to a low logic level.

If the check is successful, that is, if all of the results R₂ of the read operations are set to a low logic level, the second reset verify operation check block 106b₂ is configured to send a successful check signal Y to the end write block 114, otherwise, if the check is not successful, that is, if at least one of the results R₂ of the read operations is set to a high logic level, the second reset verify operation check block 106b₂ is configured to send an unsuccessful check signal N to a second reset write operation block 102b.

The second reset write operation block 102b is configured to receive the unsuccessful check signal N from the second reset verify operation check block 106b₂ and, in response to its reception, it is further configured to perform a reset write operation on each of the cells of the memory location that contains a bit that is to be set to a low logic level in the write operation. Such reset write operations are performed using a second current reset pulse RP₂ with a value of, for instance, 270 µA (microA): of course, that value is again merely exemplary and non-limiting.

The value of the second current reset pulse RP₂ may be higher than the value of the first current reset pulse RP₁.

The second reset write operation block 102b is further configured to send an end signal ES₄ to a first reset verify operation loop block 108a₁ after performing the reset write operations.

The first reset verify operation loop block 108a₁ is configured to receive the end signal ES₄ and, in response to its reception, it is further configured to perform one or more read operations, for instance, from a single read operation to hundreds of read operations, referred to as reset verify operations, on the cells of the memory location that contain bits that are to be set to a low logic level in the write operation and to provide a verify success variable VS₁ to a first reset verify operation loop check block 108b₁.

Such verify success variable VS₁ is set in order to record that at least one of the one or more reset verify operations is successful on each of the cells of the memory location that contains a bit that is to be set to a low logic level, that is, if at least one of the one or more reset verify operations verifies that all of the results of the read operations associated to such at least one reset verify operation are set to a low logic level.

In order to reduce the execution time of a write operation, the loop of reset verify operations may end when a first reset verify operation is successful, without performing the subsequent reset verify operations and setting the verify success variable VS₁ thereafter.

It is noted that the loop performed in the first reset verify operation loop block 108a₁ (and also in the following described reset verify operation loop blocks generally referred to with the reference 108a) may introduce additional delays between consecutive reset verify operations, for instance, if the duration of the delay introduced by the set write operation block 104 is not enough and additional time may be helpful.

The first reset verify operation loop check block 108b₁ is configured to receive the verify success variable VS₁ and to check if the verify success variable VS₁ is set, for instance, by comparing its value with a desired reference value, for instance, a logic value set to a high logic level.

If the check is successful, that is, if the value of the verify success variable VS₁ is equal to that of reference, the first reset verify operation loop check block 108b₁ is configured to send a successful check signal Y to the end write block 114, otherwise, if the check is not successful, that is, if the value of the verify success variable VS₁ is different from that of reference, the first reset verify operation loop check block 108b₁ is configured to send an unsuccessful check signal N to a third reset write operation block 102c.

The third reset write operation block 102c is configured to receive the unsuccessful check signal N from the first reset verify operation loop check block 108b₁ and, in response to its reception, it is further configured to perform a reset write operation on each of the cells of the memory location that contains a bit that is to be set to a low logic level in the write operation. Such reset write operations are performed using a third current reset pulse RP₃ with a value of, for instance, 300 µA (microA): of course, that value is once more merely exemplary and non-limiting.

The value of the third current reset pulse RP₃ may be higher than the value of the second current reset pulse RP₂.

The value of the third current reset pulse RP₃ may be higher than the value of the first current reset pulse RP₁.

Therefore, the method 10 may comprise, in response to a reset write operation considered failed, repeating the reset write operations with a current reset pulse, for instance, RP2 or RP3, of increased value.

The third reset write operation block 102c is further configured to send an end signal ES₅ to a second reset verify operation loop block 108az after performing the reset write operations.

The second reset verify operation loop block 108az is configured to receive the end signal ES₅ and, in response to its reception, it is further configured to perform one or more read operations, for instance, from a single read operation to hundreds of read operations, referred to as reset verify operations, on the cells of the memory location that contain bits that are to be set to a low logic level in the write operation and to provide a verify success variable VS₂ to a second reset verify operation loop check block 108b₂.

Such verify success variable VS₂ is set in order to record that at least one of the one or more reset verify operations is successful on each of the cells of the memory location that contains a bit that is to be set to a low logic level, that is, if at least one of the one or more reset verify operations verifies that all of the results of the read operations associated to such at least one reset verify operation are set to a low logic level.

The second reset verify operation loop check block 108bz is configured to receive the verify success variable VS₂ and to check if the verify success variable VS₂ is set, for instance, by comparing its value with a desired reference value.

If the check is successful, that is, if the value of the verify success variable VS₂ is equal to that of reference, the second reset verify operation loop check block 108bz is configured to send a successful check signal Y to the end write block 114, otherwise, if the check is not successful, that is, if the value of the verify success variable VS₂ is different from that of reference, the second reset verify operation loop check block 108bz is configured to send an unsuccessful check signal N to an optional error correction block 112.

It is noted that if such error correction block 112 is not present, such unsuccessful check signal N is directly provided to a failure block 110.

The error correction block 112 is configured to receive the unsuccessful check signal N, to count the number of cells that are currently set to a wrong logic level, that is, the number of cells for which either a set write operation or a reset write operation fails, and to check if the number of the cells that are currently set to a wrong logic level is lower than or equal to the number of bits that may be corrected with an error detecting code, for instance, by parity bits, Error Correction Bits (ECC), Error Detection Bits (EDC), Cyclic Redundancy Check (CRC), or others.

If the checking step of the error correction block 112 is successful, that is, if the number of cells that are currently set to a wrong logic level is lower than or equal to the number of bits that may be corrected with an error detecting code, the error correction block 112 is configured to send a successful check signal Y to the end write block 114 and the corresponding write operation ends successfully.

Otherwise, if the checking step of the error correction block 112 is not successful, that is, if the number of the cells that are currently set to a wrong logic level is higher than the number of bits that may be corrected with an error detecting code, the error correction block 112 is configured to send an unsuccessful check signal N to a failure block 110.

It is noted that the number of the cells that are currently set to a wrong logic level is to be computed considering both the cells that are not correctly set to a high logic level in response to a set write operation and those that are not correctly set to a low logic level in response to a reset write operation.

Such method 10 may be configured to perform the operations of the error correction block 112 prior the setting of the value of the failure variable F by the set write operation block 104.

In such a case, if the number of repetitions of set verify operations and set write operations reaches the given maximum number of repetitions, the set write operation block 104 may be configured to perform the operations of the error correction block 112 prior the setting of the value of the failure variable F and:
- if the number of the cells that are currently set to a wrong logic level, that is, the number of cells in the second set that are set to a low logic level in response to a set write operation, is lower than or equal to the number of bits that may be corrected with an error detecting code, such set write operation block 104 may be further configured to send the end signal ES₃ to the end reset check block 116b; and
- if the number of the cells that are currently set to a wrong logic level is higher than the number of bits that may be corrected with an error detecting code, such set write operation block 104 may be further configured to set the value of the failure variable F (as described previously) and to send such failure variable F to the end write block 114.

Advantageously, to avoid a high number of reset write attempts at increasing currents that may damage the cell after (many) writing cycles, that is, creating open bits that affect the durability of the PCM, data written in the cells of the selected memory location may be considered as correct even if the reset verify operations, that is, both the individual reset verify operations and the loops of reset verify operations, fail but the error correction block 112 detects that number of cells that are currently set to a wrong logic level is lower than or equal to the number of bits that may be corrected with an error detecting code.

In order to prioritize the reliability of data written in the memory locations over the durability of the PCM, data written in the cells of the selected memory location may be considered as correct if both set verify operations and reset verify operations end successfully and the error correction block 112 detects that number of cells that are currently set to a wrong logic level is lower than or equal to the number of bits that may be corrected with an error detecting code.

The failure block 110 is configured to receive the unsuccessful check signal N from the error correction block 112, to set the value of a failure variable F, for instance, by writing its value in a specific memory location or sending an alert, for instance, to the microprocessor, the microcontroller, the logic circuit, or others, in order to record that the write operation of the respective cells is considered failed, and to send such failure variable F to the end write block 114.

As previously described, the blocks of the method 10 may be considered in a different order.

For instance, in a first exemplary embodiment the first reset write operation block 102a may be considered as the first block after the start write operation block 100, and the set write operation block 104, the first reset verify operation block 106a₁, and the first reset verify operation check block 106b₁ may be considered after such first reset write operation block 102a.

In the first exemplary embodiment provided, the end reset block 116a and the end reset check block 116b may be removed as the first reset write operation block 102a may provide its output, for instance, directly, to the second reset verify operation block 106a₂ and the first reset verify operation check block 106b₁ may provide the successful check signal Y to the end write block 114.

Therefore, some of the blocks illustrated in Figure 3 may be absent from the method 10, for instance, by removing blocks 116a and 116b as explained above and/or one or more of the blocks generally indicated with 106 and/or 108 and/or the error correction block 112, and/or additional blocks may be added to the method 10, for instance, in a second exemplary embodiment, a fourth reset write operation block 102d, a third reset verify operation loop block 108a₃, and a third reset verify operation loop check block 108b₃ may be added between block 108b₂ and block 112.

It is noted that by using loops of reset verify operations on the one or more cells that are to be set to a low logic level instead of individual reset verify operations, the probability of having a second and/or a third current reset pulse RP₂ and/or RP₃ may be reduced by a high factor with respect to known solutions, for instance, in the structure disclosed in the exemplary embodiment shown in Figure 3 the probability of having a third current reset pulse RP₃ may possibly be reduced by a factor of more than about 300 times with respect to known solutions.

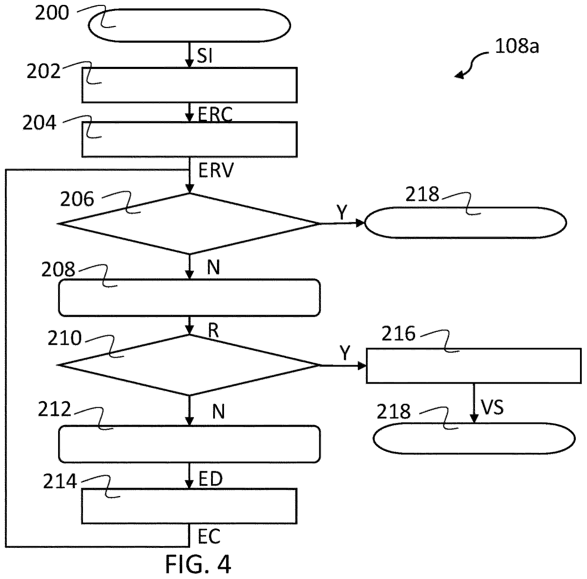

Figure 4 is a block diagram of a method 108a for performing reset verify reading attempts.

The method generally referred to as 108a for performing reset verify reading attempts may be characterized with a maximum count variable MC and a time delay variable TD.

Such method 108a may be used to implement different reset verify operation loop blocks, for instance, both the first reset verify operation loop block 108a₁ and the second reset verify operation loop block 108a₂, by setting the values of the maximum count variables MC and the time delay variables TD for each block. It is noted that different reset verify operation loop blocks may have the same or different maximum count variables values MC and/or the same or different time delay variables values TD.

Therefore, the method 10 may comprise plural loops of looped reset write verify operations 108 with different upper count value MC for such looped reset write verify operations.

Similarly, the method 10 may comprise plural loops of looped reset write verify operations with different total time, that is, TD*MD, durations of such looped reset write verify operations. Therefore, the method 10 may comprise plural loops of looped reset write verify operations with different time delay values TD of such looped reset write verify operations.

The method 108a starts in a start reset verify loop block 200 configured to receive an end signal ES from any of the blocks previously described and to send a start instruction SI to a counter reset block 202.

The counter reset block 202 is configured to receive the start instruction SI and, in response to its reception, is further configured to reset the value of a counter to a known value, for instance, to zero, and to send an end counter reset signal ERC to a verify success reset block 204.

The verify success reset block 204 is configured to receive the end counter reset signal ERC and, in response to its reception, is further configured to reset the value of a verify success variable VS to a known value, for instance, to zero, and to send an end verify reset ERV signal to a maximum count check block 206.

It is noted that even the blocks of the method 108a may be considered in a different order, for instance, the counter reset block 202 and the verify success reset block 204 may be swapped.

The maximum count check block 206 is configured to receive the end verify reset ERV signal and/or an end count EC signal and, in response to its reception, is further configured to retrieve, for instance, from a variable, a memory location, a file, or others, the value of the respective maximum count variable MC and to check if the value of the counter, that is, the number of reset verify reading attempts performed, is equal to the value of such respective maximum count variable MC, that is, the maximum allowed reset verify reading attempts.

It is noted that if all the reset verify reading attempts up to the maximum allowed reset verify reading attempts fail, the reset verify operation loop is considered as failed.

If the check is successful, that is, if the value of the counter is equal to the value of such respective maximum count variable MC, the maximum count check block 206 is configured to send a successful check signal Y to an end reset verify loop block 218, otherwise, if the check is not successful, that is, if the value of the counter is different from the value of such respective maximum count variable MC, the maximum count check block 206 is configured to send an unsuccessful check signal N to reset verify read block 208.

The respective maximum count variable MC may be programmable and set, for instance, to 100.

It is noted that the method 108a performs a number of reset verify attempts comprised in a range from one to the value of the maximum count variable MC. If a successful reset verify attempt has not occurred in a number of attempts equal to the value of the maximum count variable MC, the method 108a ends and the reset verify operation loop is considered as failed.

To summarize, the method 10 may comprise:
setting a, optionally programmable, upper count value MC for such looped reset write verify operations, and
considering 110 such looped reset write verify operations failed in response to such upper count value MC being reached without the looped reset write verify operations indicating that the at least one cell in the first set is set to a low logic level in response to the reset write operation, that is, without that a previous reset write operation was performed successfully.

The end reset verify loop block 218 is configured to receive a successful check signal Y and/or a verify success variable VS and to provide the verify success variable VS as output.

If the verify success variable VS is not received by the end reset verify loop block 218, such block 218 may be configured to provide as output a verify success variable VS set to a default value, for instance, to zero.

If the verify success variable VS is not received by the end reset verify loop block 218, such block 218 may be configured to provide as output a verify success variable VS retrieved, for instance, from a variable, a memory location, a file, or others, wherein such verify success variable VS is stored.

If the value of the verify success variable VS provided as output is equal to the reset value associated with such verify success variable VS, the plurality of reset verify reading attempts, that is, the reset verify operation loop, is considered as failed, otherwise, the reset verify operation loop is considered successful.

The reset verify read block 208 is configured to receive the unsuccessful check signal N from the maximum count check block 206 and, in response to its reception, it is further configured to perform a read operation, referred to as reset verify operation, on the cells of the memory location that contain bits that are to be set to a low logic level in the write operation and to provide the results R of such read operations to a reset verify check block 210.

The reset verify check block 210 is configured to receive the results R of the read operations and to check if all of the results R of the read operations are set to a low logic level.

If the check is successful, that is, if all of the results R of the read operations are set to a low logic level, the reset verify check block 210 is configured to send a successful check signal Y to a verify success set block 216, otherwise, if the check is not successful, that is, if at least one of the results R of the read operations is set to a high logic level, the reset verify check block 210 is configured to send an unsuccessful check signal N to a delay block 212.

The verify success set block 216 is configured to receive the successful check signal Y from the reset verify check block 210 and, in response to its reception, is further configured to set the value of the verify success variable VS to a value different from that of reset, for instance, to a high logic level, that is, "1", indicating the success of the reset verify operation loop and to send such verify success variable VS to the end reset verify loop block 218.

The delay block 212 is configured to receive the unsuccessful check signal N from the reset verify check block 210 and, in response to its reception, is further configured to retrieve, for instance, from a variable, a memory location, a file, or others, the value of the respective time delay variable TD, that is, indicating a time delay between subsequent reset verify operation attempts, and to wait for the amount of time indicated in such time delay variable TD.

The respective time delay variable TD may be programmable and set, for instance, to 1 µs.

It is noted that such time delay variable TD may be set in order to decrease the effects of the relaxation phenomenon, as after such time delay variable TD the relaxation phenomenon may be partially run out.

As previously noted, the method 108a performs a number of reset verify attempts comprised in a range from one to the value of the maximum count variable MC, therefore, if a delay equal to the time delay TD is introduced among two reset verify attempts, the maximum execution time of the reset verify operation loop is about MC*TD, for instance, if MC = 100 and TD = 1 µs, the maximum execution time is about 100 µs.

Therefore, if all the reset verify reading attempts within a time window equal to about MC*TD fail, the reset verify operation loop can be considered as failed.

To summarize, a method 10 as described herein may comprise:
setting an, optionally programmable, time delay TD between subsequent looped reset verify operations, and
considering 110 such looped reset write verify operations failed in response to a total time duration of such looped reset write verify operations being reached without the looped reset write verify operations indicating that the at least one cell in the first set is set to a low logic level in response to the reset write operation, that is, without that a previous reset write operation was performed successfully.

An optimal value for such time delay variable TD may be obtained empirically.

It is noted that reset verify attempts performed after a given reset verify attempt have a reduced failure probability since the probability to fail a reset verify operation, that is, a read operation following a write operation, decrease over time according to the relaxation phenomenon.

Therefore, the time delay TD may be selected by considering a desired balance between the maximum execution time of the reset verify operation loop and the probability to fail a reset verify operation, for instance, obtained by empirically testing the decreasing of the failure probability over time according to the relaxation phenomenon.

The delay block 212 is further configured to provide an end delay ED signal indicating the end of the waiting to a counter block 214.

The counter block 214 is configured to receive the end delay ED signal and, in response to its reception, is further configured to add, for instance, a unitary value, to the value of the counter and to send the end count EC signal to the maximum count check block 206.

The methods 10 and 108a described here can be implemented using one or more computer products loadable in a memory of at least a computer and comprising portions of software code for executing the previously described phases.

Solutions as described herein facilitate achieving a method for reducing the failure probability of reset verify operations using a balance between individual reset verify operations and loops of reset verify operations, considered respectively to minimize the impact of relaxation on write operations time and improve the reliability of read operations to avoid a high number of reset write attempts at increasing currents that may damage the cell after many writing cycles.

Thus, solutions as described herein facilitate achieving single-ended PCM architectures that minimize, that is, reduce or substantially remove, the impact of the resistance drift of a phase-change material, reducing production costs and the required area of PCM architectures without sacrificing their durability.

In addition, solutions as described herein facilitate achieving a desired balance between reliability and time of execution by balancing the number of individual reset verify operations and loops of reset verify operations, wherein such loops of reset verify operations may additionally reduce the probability of having a second and/or a third current reset pulse, increasing the durability of the PCM and avoiding open bits.

Without prejudice to the underlying principles, the details and the embodiments may vary, even significantly, with respect to what has been described by way of example only without departing from the scope of the embodiments.

The extent of protection is determined by the annexed claims.

## Claims

1. A method (10) of performing write operations in a Phase Change Memory, PCM device, the PCM device comprising a first set of cells and a second set of cells configured to be set to a low logic level and to a high logic level, respectively, in response to write operations comprising reset write operations and/or set write operations,
wherein the method (10) comprises:
if the first set contains at least one cell set at a high logic level, performing (102) a reset write operation to set to a low logic level said at least one cell in the first set by applying thereto at least one current reset pulse (RP1; RP2; RP3),
if the second set contains at least one cell set at a low logic level, performing (104) a set write operation to set to a high logic level said at least one cell in the second set,
verifying (104) success or failure of the set write operation via at least one set verify operation to check if the at least one cell in the second set is set to a high logic level in response to the set write operation,
considering (104) the set write operation:
i) successful, in response to said at least one set verify operation indicating that the at least one cell in the second set is set to a high logic level in response to the set write operation, and
ii) failed, in response to said at least one set verify operation indicating that the at least one cell in the second set is set to a low logic level in response to the set write operation;
verifying (110) success or failure of the reset write operation via at least one verify operation selected out of individual (106) and looped (108) reset write verify operations to check if the at least one cell in the first set is set to a low logic level in response to the reset write operation,
considering (110) the reset write operation:
i) successful, in response to any of said individual (106) and looped (108) reset write verify operations indicating that the at least one cell in the first set is set to a low logic level in response to the reset write operation, and
ii) failed, in response to all of said individual (106) and looped (108) reset write verify operations indicating that the at least one cell in the first set is set to a high logic level in response to the reset write operation; and
considering the write operation as failed in response to said reset write operation being considered as failed (110) and/or to said set write operation being considered as failed (104).

2. The method (10) of claim 1, wherein the method comprises considering (110) the reset write operation successful and discontinuing verifying (110) success or failure of the reset write operation in response to a first reset write verify operation indicating that the at least one cell in the first set is set to a low logic level in response to the reset write operation.

3. The method (10) according to claim 1 or claim 2, comprising performing at least one individual reset write verify operation (106) prior to any looped reset write verify operations (108) and/or at least one reset write operation (102) prior to any set write operation (104).

4. The method (10) according to any of the previous claims, comprising considering (110) a looped reset write verify operation failed in response to a, preferably programmable, respective upper count value (MC) being reached without the looped reset write verify operations indicating that the at least one cell in the first set is set to a low logic level in response to the reset write operation.

5. The method (10) according to claim 4, comprising plural loops of looped reset write verify operations with different respective upper count values (MC) for said looped reset write verify operations.

6. The method (10) according to any of the previous claims, comprising considering (110) a looped reset write verify operation failed in response to a, preferably programmable, respective total time duration of the looped reset verify operation being reached without the looped reset write verify operation indicating that the at least one cell in the first set is set to a low logic level in response to the reset write operation.

7. The method (10) according to claim 6, wherein, with said looped reset write verify operation comprising a loop of individual reset verify operations, the method comprises setting a, preferably programmable, time delay value (TD) between individual reset verify operations in the loop.

8. The method (10) according to claim 6 or claim 7, comprising plural loops of looped reset write verify operations with different total time durations of said looped reset write verify operations.

9. The method (10) according to any of the previous claims, further comprising:
counting (112) the number of cells comprised in the first set that are set to a high logic level in response to the reset write operation (102) and the number of cells comprised in the second set that are set to a low logic level in response to the set write operation (104),
checking (112) if the result of said counting (112) operation is lower than or equal to a number of bits correctable though an error detecting code, and
considering (112) the result of said checking (112) as successful if said result of said counting operation (112) is lower than or equal to said number of correctable bits or unsuccessful if said result of said counting operation (112) is higher than said number of correctable bits.

10. The method (10) according to any of the previous claims, wherein the method comprises considering (104) the write operation failed and discontinuing further operations in response to each of the at least one set verify operation indicating that the at least one cell in the second set is set to a low logic level in response to the set write operation.

11. The method (10) according to claim 9, wherein the method comprises performing said counting (112) operation, said checking (112) operation, and said considering (112) operation in response to each of the at least one set verify operation indicating that the at least one cell in the second set is set to a low logic level in response to the set write operation, and if said checking (112) operation is considered unsuccessful, discontinuing further operations and considering (104) the write operation failed.

12. The method (10) according to any of the claims 9 to 11, wherein said write operation is considered successful in response to:
- said reset write operation being considered as successful (110) and said set write operation being considered as successful (104); and/or
- said checking (112) operation being considered successful, irrespective of the outcome of said reset write operations and said set write operations.

13. The method (10) according to any of the previous claims, comprising,
in response to a reset write operation considered failed, repeating the reset write operations with current reset pulse (RP2; RP3) of increased value, and/or
in response to a set write operation considered failed, repeating the set write operations with current set pulse of increased value.

14. A Phase Change Memory, PCM device comprising a first set of cells and a second set of cells configured to be set to a low logic level and to a high logic level, respectively, in response to a write operation, the PCM device configured to implement the method according to any of the previous claims.

15. A computer program product loadable in a control unit of a Phase Change Memory, PCM device, the PCM device comprising a first set of cells and a second set of cells configured to be set to a low logic level and to a high logic level, respectively, the computer program product comprising portions of software code configured to cause the PCM device to implement the method according to any of claims 1 to 13 in response to the computer program product being run in the control unit of the PCM device.
